# EUROPÄISCHE PATENTANMELDUNG

(11) **EP 1 739 440 A2**
(43) Veröffentlichungstag der Anmeldung: **03.01.2007**
(21) Anmeldenummer: 06012706.5
(22) Anmeldetag: 21.06.2006
(51) Int. Cl.: G01R 1/073

(54) **Elektrisches Prüfverfahren und -vorrichtung sowie Verfahren zur Herstellung einer Kontaktiervorrichtung**

(30) Priorität: 30.06.2005 DE 10530496; 16.06.2006 DE 10628141
(71) Anmelder: Feinmetall GmbH, 71083 Herrenberg (DE)
(72) Erfinder: Böhm, Gunther, 71154 Nufringen (DE)
(74) Vertreter: Grosse, Rainer

(57) **Zusammenfassung**

Die Erfindung betrifft eine Kontaktiervorrichtung zum elektrischen Verbinden eines Prüflings mit einer elektrischen Prüfeinrichtung, mit mehreren, mindestens einem Halteelement zugeordneten elektrischen Kontakten. Es ist vorgesehen, dass die Kontaktiervorrichtung (1), vorzugsweise das Halteelement (3), mit mindestens einer Markierung (25) versehen ist, die eine definierte Lage zu mindestens einem der Kontakte (7) aufweist. Ferner betrifft die Erfindung ein entsprechendes Verfahren.

## Beschreibung

Die Erfindung betrifft ein Verfahren zum elektrischen Prüfen eines Prüflings, der über eine Kontaktiervorrichtung mit einer elektrischen Prüfeinrichtung verbunden wird, wobei die Kontaktiervorrichtung an mindestens einem Halteelement mehrere elektrische Kontakte für die Kontaktierung von Gegenkontakten des Prüflings aufweist und wobei mittels Unterstützung optischer Erfassungen von Kontaktiervorrichtung und Prüfling die Kontakte und Gegenkontakte zueinander positioniert werden.

Zur elektrischen Funktionsprüfung eines elektrischen Prüflings, beispielsweise eines Wafers, wird diese mittels einer Kontaktiervorrichtung mit einer elektrischen Prüfeinrichtung verbunden. Die Kontaktiervorrichtung weist an mindestens einem Halteelement mehrere elektrische Kontakte für die Kontaktierung von Gegenkontakten des Prüflings auf. Kontakte und Gegenkontakte werden mit Hilfe einer optischen Einrichtung relativ zueinander ausgerichtet. Anschließend erfolgt die Kontaktierung, d.h., die Gegenkontakte des Prüflings treten in Berührungskontakt zu den Kontakten der Kontaktiervorrichtung. Hierdurch wird die elektrische Prüfeinrichtung mit dem Prüfling verbunden, so dass Durchgangsmessungen, Isolationsmessungen usw. durchgeführt werden können. Mittels der optischen, vorzugsweise als Kamera ausgebildeten Einrichtung werden nicht alle Kontakte der Kontaktiervorrichtung erfasst, um den Prüfvorgang zu beschleunigen. Die Erfassung erfolgt insbesondere nur an signifikanten Stellen, beispielsweise durch Erfassung von Eckkontakten. Hierdurch besteht die Gefahr, dass eine falsche Position für die Kontaktierung berechnet wird, wenn beispielsweise mehrere gleiche oder ähnliche Kontaktmuster bei der Kontaktiervorrichtung vorliegen.

Ferner ist eine Kontaktiervorrichtung bekannt, deren elektrische Kontakte für die Prüfung eines Prüflings an Gegenkontakte des Prüflings angedrückt werden. Die Kontaktiervorrichtung steht mit einer elektrischen Prüfeinrichtung in Verbindung, sodass über die geschaffenen Stromwege eine elektrische Prüfung des Prüflings erfolgen kann. Auf diese Art und Weise lassen sich beispielsweise Wafer zur Fertigung von Halbleiterchips prüfen. Um eine einwandfreie Kontaktierung der Gegenkontakte bildenden Kontakte des Prüflings mit den Kontakten der Kontaktierreinrichtung vornehmen zu können, ist es bekannt, dass mittels einer Kamera beziehungsweise eines Kamerasystems die Lage der Kontakte der Kontaktiervorrichtung und die Lage der Gegenkontakte des Prüflings erfasst und durch entsprechende Verlagerung der Kontaktiervorrichtung und/oder des Prüflings zur Deckung/Fluchtung gebracht werden. Um diesen Vorgang zu beschleunigen, werden nicht alle Kontakte der Kontaktiervorrichtung von der Kamera erfasst, sondern nur signifikante Stellen, wie beispielsweise Eckkontakte, das heißt Kontakte, die hinsichtlich der Kontaktanordnung an Eckpunkten liegen. Bei Mehrfach-Probing, also einer Prüfung, bei der beispielsweise mehrere IC-Bausteine auf einem Wafer gleichzeitig getestet werden, besteht die Gefahr, dass eine falsche Position für die Kontaktierung berechnet wird, da es mehrere gleiche oder ähnliche Kontaktmuster bei der Kontaktiervorrichtung und/oder dem Prüfling gibt. Es besteht auch die Gefahr, dass der Vorgang des Ausrichtens sehr lange dauert oder sogar manuell durchgeführt werden muss.

Der Erfindung liegt daher die Aufgabe zugrunde, ein Verfahren zum elektrischen Prüfen eines Prüflings der eingangs genannten Art zu schaffen, bei dem die Ausrichtung der Kontakte der Kontaktiervorrichtung zu den Gegenkontakten des Prüflings sehr schnell und präzise sowie fehlerfrei durchgeführt werden kann.

Diese Aufgabe wird erfindungsgemäß dadurch gelöst, dass zur Positionsbestimmung mindestens eine eine definierte Lage zu mindestens einem der Kontakte aufweisenden Markierung der Kontaktiervorrichtung optisch erfasst wird. Aufgrund der Markierung ist es nicht mehr erforderlich, bestimmte Kontakte der Kontaktiervorrichtung sicher zu erkennen, wobei es sich um die "richtigen" Kontakte handeln muss, denn durch die Erfassung der Markierung lässt sich in Relation zu den Gegenkontakten des Prüflings einwandfrei die Relativlage der Kontakte und Gegenkontakte bestimmen, so dass eine fehlerfreie Kontaktierung von Kontakten und Gegenkontakten und eine schnelle Prüfung des Prüflings möglich ist. Insbesondere können mehrere Markierungen an der Kontaktiervorrichtung vorgesehen sein, die optisch erfasst werden. Bei einer Markierung handelt es sich demzufolge nicht um einen Kontakt oder um eine bestimmte Kontaktanordnung, sondern um eine separate Kennzeichnung, die eine definierte Lage zu mindestens einem der Kontakte, vorzugsweise zu mehreren der Kontakte, aufweist. Ermittelt die optische Einrichtung die mindestens eine Markierung, so können entsprechende Daten einer Auswerteeinrichtung zugeführt. Diese kennt die Relativlage der Markierung zu den Kontakten oder mindestens einem der Kontakte und ist daher in der Lage die Relativlage zwischen den Kontakten und Prüfling, insbesondere dessen Gegenkontakte, zu ermitteln. Die Erfassung des Prüflings, insbesondere der Gegenkontakte des Prüflings, erfolgt mittels derselben oder einer anderen optischen Einrichtung, die ebenfalls ihre Daten an die Auswerteeinrichtung liefert. Zum Kontaktieren ist es dann nur noch erforderlich, den Prüfling relativ zu den Kontakten auszurichten und dann die Kontaktierung vorzunehmen.

Nach einer Weiterbildung der Erfindung ist vorgesehen, dass als Markierung mindestens eine Markierung des Halteelements optisch erfasst wird, d.h., die Markierung befindet sich an dem Halteelement.

Ferner ist es vorteilhaft, wenn für die Ausrichtung von Kontaktiervorrichtung und Prüfling der Prüfling relativ zur ortsfesten Kontaktiervorrichtung positioniert/verlagert wird. Der Prüfling ist demgemäß z.B. in X- und Y-Richtung verfahrbar, wobei in Z-Richtung die Kontaktierung zwischen den Kontakten und Gegenkontakten erfolgt. In der X-Y-Ebene ist vorzugsweise ferner eine Winkelausrichtung (Winkel Theta) möglich. Dies bedeutet, dass der Prüfling in der X-Y-Ebene verschwenkt werden kann.

Nach einer Weiterbildung der Erfindung ist die mindestens eine Markierung bevorzugt seitlich neben den Kontakten angeordnet.

Um den Prüfling bei der Prüfung festzuhalten, wird er vorzugsweise auf einer verfahrbaren Unterlage, (einem sogenannten Chuck) gehalten. Das Halten erfolgt vorzugsweise per Unterdruck. Bei dem Prüfling kann es sich um eine elektrische oder elektronische Einrichtung, beispielsweise einem Wafer handeln, der mit einer Vielzahl von Chips versehen ist, die zu prüfen sind.

Die Kontaktiervorrichtung ist vorzugsweise als Prüfkarte, sog. Probe Card ausgebildet.

Wie bereits angedeutet, können mehrere Markierungen, beispielsweise mindestens zwei Markierungen, an der Kontaktiervorrichtung vorhanden sein, die optisch verfasst werden.

Insbesondere ist vorgesehen, dass die mindestens zwei Markierungen derart angeordnet werden, dass sie gleich weit oder etwa gleich weit entfernt von einem Zentrum der Anordnung der Kontakte liegen. Bei diesem Zentrum handelt es sich um ein gedachtes Zentrum, das bei Draufsicht auf die Kontaktverteilung der elektrischen Kontakte etwa im Zentrum der Fläche liegen, in denen sich die elektrischen Kontakte befinden. Wenn nun die beiden Markierungen von diesem Zentrum gleich weit oder etwa gleich weit entfernt liegen, so führt eine Schwenkbewegung um das Zentrum, beispielsweise in der Größe eines Winkels Theta, dazu, dass eine optimale Winkelkorrektur erfolgen kann. Dies ist insbesondere bei einer unsymmetrischen Kontaktanordnung von Bedeutung, da es bei derartigen Kontaktanordnungen häufig zu Problemen kommen kann, denn beim Ausrichtvorgang, der selbsttätig durchgeführt wird, geht die Auswertevorrichtung immer von einer reinen Theta-Verdrehung aus. Würde um ein Zentrum gedreht werden, dass nicht etwa in der gedachten Mitte (Zentrum) der in einem bestimmten Muster vorliegenden Kontaktanordnung liegt, so würde eine Winkelverdrehung gleichzeitig zu einem sehr unterschiedlichen Versatz der einzelnen Kontakte in X- und in Y-Richtung führen, d.h., es liegt nur eine suboptimale Korrektur vor. Befindet sich jedoch der Schwenkpunkt bzw. Drehpunkt etwa im Zentrum des "Kontaktmusters", so kann auf sehr einfache Art und Weise eine Winkelkorrektur durchgeführt werden.

Nach einer Weiterbildung der Erfindung ist vorgesehen, dass der Prüfling unter Zuhilfenahme seiner optischen Erfassung bezüglich eines virtuellen Koordinatensystems in Bezug auf die optisch erfasste Lage der mindestens einen Markierung vorausgerichtet wird (Grobausrichtung). Die optische Erfassung des Prüflings beinhaltet vorzugsweise die Erfassung seiner Gegenkontakte. Die Relativlage der Kontakte der Kontaktiervorrichtung zu den Gegenkontakten wird durch optische Erfassung der mindestens einen Markierung festgestellt.

Ferner ist vorteilhaft, dass nach der Vorausrichtung eine Feinausrichtung des Prüflings relativ zur Kontaktiervorrichtung, insbesondere zu deren Kontakten erfolgt. Für die Feinausrichtung wird die mindestens eine Markierung der Kontaktiervorrichtung optisch erfasst. Wie bereits erwähnt, erfolgt die Vorausrichtung und/oder die Feinausrichtung durch Vergleich der optisch erfassten Ergebnisse von der mindestens einen Markierung und dem Prüfling. Nach der Feinausrichtung erfolgt die Kontaktierung des Prüflings mittels der Kontakte in einer Prüfposition. Es können weitere Prüfpositionen bei der Prüfung des selben Prüflings eingenommen werden, wobei dies jedoch ohne nochmaligen optischen Vergleich gemäß der vorstehenden Ausführungen erfolgt, sondern aufgrund geometrischer Vorgaben. Wenn also mehrer elektronischen Schaltungen, z.B. Chips, auf einen Wafer angeordnet sind, so ist deren Relativlage aufgrund geometrischer Vorgaben bekannt. Bei der Prüfung kann dann durch entsprechendes Verfahren des Chucks jede der Elektronikschaltungen/ICs/Chips usw. angefahren werden.

Sämtliche vorstehenden Ausführungen beziehen sich auf ein selbsttätiges Arbeiten, d.h., das Ausrichten und Kontaktieren des Prüflings mittels der Kontakte der Kontaktiervorrichtung erfolgt vollautomatisch.

Ferner ist es vorteilhaft, wenn mindestens eine Markierung als Mehrfachmarkierung, insbesondere Doppelmarkierung, mit mindestens einer Grobstruktur und mindestens einer Feinstruktur ausgebildet wird und dass die Positionierung/Ausrichtung anhand der Grobstruktur mittels optischer, mit niedriger Auflösung erfolgender Erfassung der Grobstruktur und dann anhand der Feinstruktur mittels optischer, mit hoher Auflösung erfolgender Erfassung der Feinstruktur durchgeführt wird. Hierdurch wird eine große Genauigkeit in kurzer Zeit erzielt.

Insbesondere ist vorgesehen, dass die Feinstruktur innerhalb der Grobstruktur angeordnet wird, d.h., das Markierungszentrum von Grobstruktur und Feinstruktur fallen zusammen. Insbesondere ist dabei vorgesehen, dass die Grobstruktur mit niedriger optischer Auflösung erfasst wird und dass dann für die Feinausrichtung die Feinstruktur mit einer höheren Auflösung für die Relativlagenbestimmung von Kontakten und Gegenkontakten erfasst wird.

Die Erfindung betrifft ferner eine Vorrichtung, insbesondere zur Durchführung des vorstehend genannten Verfahrens, mit einer Kontaktiervorrichtung zum elektrischen Verbinden eines Prüflings mit einer elektrischen Prüfeinrichtung, mit mehreren, mindestens einem Halteelement zugeordneten elektrischen Kontakten für die Kontaktierung von Gegenkontakten eines Prüflings, wobei die Kontaktiervorrichtung, vorzugsweise das Halteelement, mit mindestens einer Markierung versehen ist, die eine definierte Lage zu mindestens einem der Kontakte aufweist und mit mindestens einer die Markierung und den Prüfling, insbesondere die elektrischen Gegenkontakte des Prüflings, erfassenden optischen Einrichtung. Die Markierung stellt sicher, dass die Lage der Kontaktiervorrichtung von der mindestens einen optischen Einrichtung, insbesondere einer Kamera oder einem Kamerasystem, einwandfrei erkannt wird, wobei dadurch auch die Lage der Kontakte bekannt ist, da die Markierung einen festen, bekannten Bezug zu den Kontakten aufweist. Demzufolge lässt sich aufgrund der Erfindung die Lage der Kontaktiervorrichtung und damit die Lage der Kontakte relativ zum Prüfling sehr schnell und eineindeutig ermitteln, sodass es bei der nachfolgenden Prüfung auch bei Mehrfach-Probing nicht zu Fehlern oder falschen Positionen kommt. Ferner wird der Ausrichtvorgang sehr stark beschleunigt, da die erfindungsgemäße Markierung sehr schnell und reproduzierbar ermittelt werden kann.

Ferner ist es vorteilhaft, dass mindestens eine Positioniervorrichtung zur selbsttätigen Ausrichtung von Kontakten und Gegenkontakten relativ zueinander unter Berücksichtigung der optischen Erfassung vorgesehen ist.

Die mindestens eine Markierung weist bevorzugt eine Grobstruktur und eine Feinstruktur auf. Grobstruktur und Feinstruktur besitzen vorzugsweise dasselbe Markierungszentrum.

Es ist vorteilhaft, wenn die am Halteelement angeordnete Markierung gegenüber dem Haltelement mit optischem Kontrast ausgebildet ist. Der optische Kontrast verbessert die Erfassung durch die optische Einrichtung.

Nach einer Weiterbildung der Erfindung ist vorgesehen, dass die am Halteelement angeordnete Markierung gegenüber dem Halteelement mit optischem Kontrast ausgebildet ist. Durch den Kontrast zwischen dem Halteelement und der Markierung wird letztere von der Kamera oder dem Kamerasystem schnell und eindeutig erkannt.

Ferner ist es vorteilhaft, wenn die Markierung auf seiner dem Prüfling zugeordneten Seite des Halteelements angeordnet ist. Hierdurch lässt sich insbesondere mit nur einer Kamera sowohl die Position des Prüflings hinsichtlich seiner Gegenkontakte als auch die der Markierung und damit der elektrischen Kontakte bestimmen, was beispielsweise mittels eines der Kamera zugeordneten halbdurchlässigen Spiegels möglich ist, der eine Erfassung in 180° zueinander liegenden Richtung gestattet.

Ferner ist es vorteilhaft, wenn das Halteelement Durchbrüche aufweist, in denen die Kontakte angeordnet, vorzugsweise verschieblich, insbesondere vertikal verschieblich, geführt sind.

Die Kontakte können insbesondere als Knickdrähte ausgebildet sein.

Die Erfindung betrifft ferner ein Verfahren zur Herstellung einer Kontaktiervorrichtung zum elektrischen Verbinden eines Prüflings mit einer elektrischen Prüfeinrichtung, mit mehreren elektrischen Kontakten, die Durchbrüchen mindestens eines Halteelements zugeordnet sind, wobei die Kontaktiervorrichtung, insbesondere das Halteelement, mit mindestens einer Markierung versehen wird, die eine definierte Lage zu mindestens einem der Kontakte aufweist, wobei die Markierung mit derselben Bearbeitungsvorrichtung/Bearbeitungsart hergestellt wird, die auch die Durchbrüche erzeugt. Aufgrund dessen, dass dieselbe Bearbeitungsvorrichtung und/oder dieselbe Bearbeitungsart eingesetzt wird, ist sichergestellt, dass eine definierte Position der Markierung relativ zu einem Kontakt oder mehreren Kontakten besteht, es liegt demzufolge ein reproduzierbarer, bekannter Abstand, auch räumlich gesehen, vor.

Ferner ist es vorteilhaft, wenn die Ausbildung der Durchbrüche und der Markierung in der selben Aufspannung erfolgen. Das heißt, beim Erzeugen der Durchbrüche und der Markierung erfolgt kein Umspannen der Kontaktiervorrichtung (oder eines Bauteils von ihr), sondern diese wird in ein und derselben Aufspannung gehalten, wodurch Positionierfehler und/oder Toleranzfehler vermieden sind.

Insbesondere wird als Bearbeitungsart eine Laserbearbeitung und/oder eine mechanische Bearbeitung durchgeführt.

Es ist vorteilhaft, wenn die Markierung als Mehrfachmarkierung, insbesondere als Doppelmarkierung, erzeugt wird und dass die einzelnen Markierungen der Mehrfachmarkierung (Teilmarkierungen der Mehrfachmarkierungen) mit derselben Bearbeitungsvorrichtung und/oder Bearbeitungsart und/oder derselben Aufspannung hergestellt werden. Hierdurch wird eine hochgenaue Relativlage zwischen Grobmarkierung und Feinmarkierung bzw. zwischen den einzelnen Markierungen der Mehrfachmarkierung erreicht. Insbesondere ist vorgesehen, dass alle Markierungen der Mehrfachmarkierungen dasselbe Markierungszentrum aufweisen. Unter "Aufspannung" ist zu verstehen, dass bei der Bearbeitung das entsprechende Werkstück zum Markieren befestigt, also aufgespannt werden muss. Wird diese Aufspannung beibehalten, wenn die mehreren Teilmarkierungen (z.B. Grobmarkierung und Feinmarkierung) erstellt werden, wird das Werkstück also nicht zwischendurch ausgespannt, so ist eine hohe Präzision erzielt.

Nach einer Weiterbildung der Erfindung ist ― wie bereits erwähnt ― vorgesehen, dass die Markierung als Mehrfachmarkierung, insbesondere Doppelmarkierung, mit einer Grobstruktur und einer Feinstruktur ausgebildet ist. Hierunter ist beispielsweise bei einer als Strichkreuz ausgebildeten Markierung ein Grobkreuz mit einer entsprechend dicken Strichstärke zu verstehen. Innerhalb dieser Grobstruktur befindet sich eine Feinstruktur, die ebenfalls als Strichkreuz ausgebildet ist, jedoch mit einer sehr feinen Strichstärke. Beide Kreuze haben einen gemeinsamen Kreuzungspunkt. Im Zuge der Ausrichtung der Kontakte und Gegenkontakte zueinander wird von einer optischen Einrichtung mit einer entsprechend niedrigen Auflösung zunächst die Grobstruktur, also das Kreuz mit der dicken Strichstärke erfasst und eine Grobausrichtung vorgenommen. Ist dies erfolgt, so wird im Zuge der gesamten Ausrichtung die optische Auflösung des optischen Systems, insbesondere der Kamera, erhöht, sodass die Feinstruktur erfasst werden kann und eine Feinausrichtung ermöglicht. Nach Abschluss der Feinausrichtung sind die Kontakte und Gegenkontakte exakt zueinander ausgerichtet.

### Die Zeichnung veranschaulicht die Erfindung, und zwar zeigt:

- Figur 1: eine schematische Seitenansicht auf eine Kontaktiervorrichtung,
- Figur 2: eine Unteransicht auf den Prüfkopf der Kontaktiervorrichtung der Figur 1 und
- Figur 3: eine zwischen Kontaktiervorrichtung und Prüfling eingefahrene Kamera zur Erfassung der Lage und zur Durchführung einer Ausrichtung vor einem Prüfvorgang.

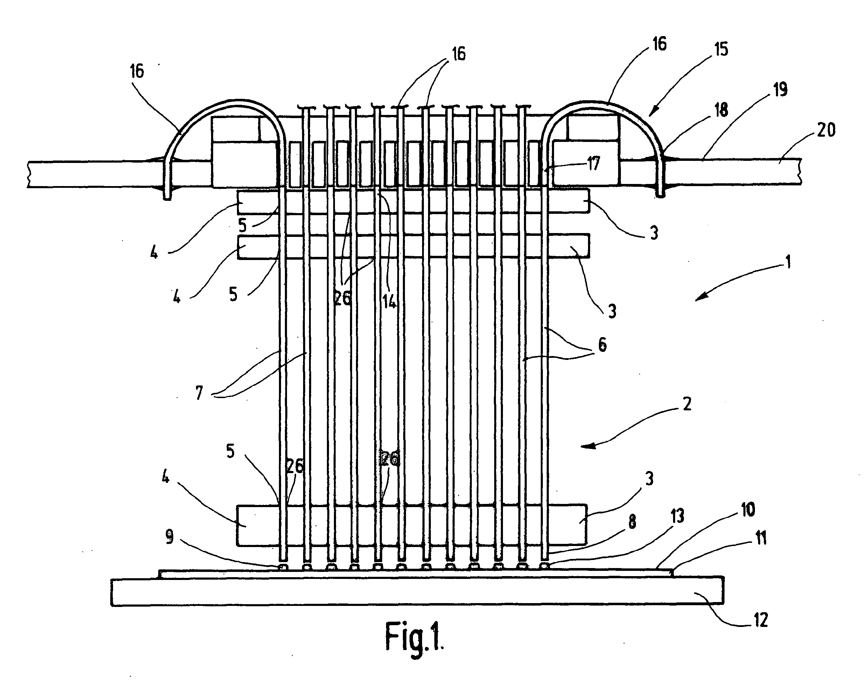

Die Figur 1 zeigt eine Kontaktiervorrichtung 1, die einen Kontaktkopf 2 aufweist, der Halteelemente 3 in Form von Führungsplatten 4 besitzt. Die Führungsplatten 4 werden Durchbrüchen 26, insbesondere von Führungsbohrungen 5, durchsetzt, in denen als Knickdrähte 6 ausgebildete Kontakte 7 angeordnet sind. Die in der Figur 1 unteren Enden 8 der Kontakte 7 dienen zur Berührungskontaktierung von Kontakten 9 eines Prüflings 10, der beispielsweise als Wafer 11 ausgebildet sein kann und auf einer Unterlage 12 zur Abstützung liegt. Die Kontakte 9 des Prüflings 10 bilden demgemäß Gegenkontakte 13 für die Kontakte 7. Die den Enden 8 gegenüberliegenden Enden 14 der Kontakte 7 wirken mit einer Umsetzeinrichtung 15 zusammen, die entsprechend dem Muster der Kontakte 7 angeordnete Kontaktdrähte 16 aufweist. Die Enden 17 der Kontaktdrähte 16 treten in Berührungskontakt mit den Enden 14 der Kontakte 7 und die anderen Enden 18 der Kontaktdrähte 16 sind mit Leiterbahnen 19 einer Leiterplatte 20 verlötet. Die Leiterbahnen 19 der Leiterplatte 20 führen zu einer elektrischen Prüfeinrichtung oder die Leiterplatte 20 ist Bestandteil der elektrischen Prüfeinrichtung.

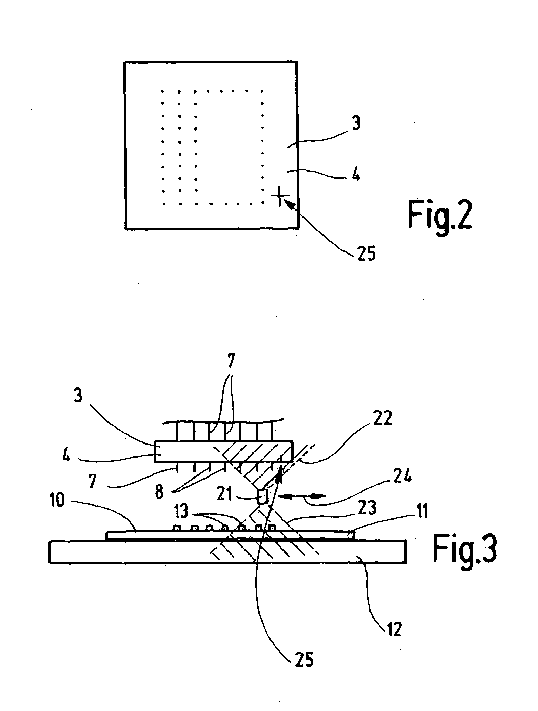

Für die elektrische Prüfung des Prüflings 10 ergibt sich folgende Funktion: Durch Relativverlagerung der Kontaktiervorrichtung 1 und des Prüflings 10 (nebst Unterlage 12) zueinander, treten die Enden 8 der Kontakte 7 auf die Gegenkontakte 13 des Prüflings 10. Nunmehr kann die nicht dargestellte elektrische Prüfeinrichtung testen, ob der Prüfling elektrisch einwandfrei ist. Hierzu werden entsprechende Prüfströme oder dergleichen über die Leiterbahnen 19 der Leiterplatte 20, die Kontaktdrähte 16, die Kontakte 7 und die Gegenkontakte 13 zum Prüfling 10 geleitet. Aus dem Vorstehendem wird deutlich, dass es für eine einwandfreie Kontaktierung des Prüflings 10 erforderlich ist, dass die Enden 8 der Kontakte 7 genau mit den Gegenkontakten 13 des Prüflings 10 fluchten. Demgemäss ist es vor einer Kontaktierung des Prüflings 10 erforderlich, die Kontaktiervorrichtung 1 in X- und Y-Richtung auszurichten, bevor in Z-Richtung die Kontaktierung erfolgt. Hierzu wird eine Kamera 21 (Figur 3) verwendet, die in zwei zueinander entgegengesetzte Richtungen eine Erfassung vornehmen kann. Ein gestrichelt eingezeichneter Kegel 22 deutet die Blickrichtung der Kamera von unten auf den Prüfkopf 2 an, ein Kegel 23 verdeutlicht die Blickrichtung der Kamera 21 nach unten auf den Prüfling 10. Der Doppelpfeil 24 deutet das Einfahren der Kamera 21 zwischen die genannten Baugruppen und das Aüsfahren aus dem Raum zwischen den Baugruppen an.

Um nun eine eineindeutige Position der Kontakte 7 des Prüfkopfes 2 mittels der Kamera 21 ermitteln zu können, ist - gemäß der Figuren 2 und 3 - vorgesehen, am Halteelement 3, insbesondere an der dem Prüfling 10 benachbarten Führungsplatte 4 mindestens eine Markierung 25, vorzugsweise zwei zueinander beabstandete Markierungen 25, anzubringen, die eine definierte Lage zu mindestens einem Kontakt 7, vorzugsweise zu mehreren Kontakten 7, insbesondere zu den Enden 8 der Kontakte 7, aufweist. Die mindestens eine Markierung 25 wird von der Kamera 21 erfasst. Da die Zuordnung der mindestens einen Markierung zu den Kontakten 7 festgelegt und in einem Datenverarbeitungsprogramm hinterlegt ist, lässt sich auf sehr schnelle und einfache Weise die Lage der Kontakte 7 mittels eines automatisch arbeitenden Ausrichtsystems erfassen und gegebenenfalls eine Ausrichtung von Kontaktiervorrichtung 1 relativ zum Prüfling 10 vornehmen. Da die Kamera 21 auch die Gegenkontakte 13 des Prüflings 10 erfasst, können etwaige Fluchtungsfehler zwischen den Kontakten 7 und den Gegenkontakten 13 ermittelt werden. Das Erfassen der mindestens einen Markierung 25 lässt sich von der Kamera 21 des Kamerasystems sehr schnell bewerkstelligen, ohne dass es zu Fehlern kommt, die beispielsweise bei Mehrfach-Probing auftreten, wenn mehrere IC-Bausteine auf einem Wafer angeordnet sind, die gleichzeitig gestestet werden sollen. Es besteht dann die Gefahr, dass ein nicht dargestellter Prober (Handlinggerät für den Wafer) eine falsche Position für die Kontaktierung berechnet, wenn es mehrere gleiche Kontaktmuster auf dem Prüfkopf gibt oder dass dieser Vorgang sehr lange dauert oder sogar manuell durchgeführt werden muss. Die vorstehenden Probleme treten jedoch nur dann auf, wenn - wie bekannt - die Kontakte 7 von der Kamera selbst erfasst werden. Da erfindungsgemäß jedoch zur Erfassung der Lage der Kontakte 7 die mindestens eine Markierung 25 herangezogen wird, wobei zwischen der Markierung 25 und mindestens einem der Kontakte 7 eine feste, dem Gesamtsystem bekannte Zuordnung besteht, so lässt sich fehlerfrei schnell und problemlos die Positionsbestimmung mittels der Kamera 21 durchführen, wenn diese nur die Markierung 25 und nicht die Kontakte 7 erfasst/auswertet.

Selbstverständlich ist es möglich, dass mehrere, zum Beispiel drei Markierungen 25 vorgesehen sind. Ferner ist es auch denkbar, dass sich die mindestens eine Markierung 25 an einer anderen Stelle als an der Unterseite der untersten Führungsplatte 4 befindet. Wichtig ist lediglich, dass mittels mindestens einer Markierung die Lage der Kontakte 7 schnell und fehlerfrei von dem Kamerasystem erfasst und anschließend eine schnelle und fehlerfreie Positionierung automatisch durchgeführt werden kann, um anschließend eine korrekte Kontaktierung des Prüflings 10 vornehmen zu können. Demgemäss arbeitet das Kamerasystem mit einem Datenverarbeitungssystem und mindestens einem Handlinggerät zusammen, um eine Ausrichtung in X- und Y-Richtung zur Fluchtung der Kontakte 7 und Gegenkontakte 13 vornehmen zu können. Anschließend erfolgt dann nach Herausfahren der Kamera 21 aus der Kontaktzone die Kontaktierung des Prüflings 10 in Z-Richtung.

Um die mindestens eine Markierung 25 gegenüber der Kontaktiervorrichtung 1, insbesondere dem Halteelement 3, deutlicher hervortreten zu lassen, ist diese mit optischem Kontrast zum Halteelement 3 ausgebildet. Als Markierung kann beispielsweise ein Kreuz eingesetzt werden oder andere Muster, die eine eineindeutige Positionsbestimmung ermöglichen.

Bevorzugt kann vorgesehen sein, dass die mindestens eine Markierung 25 mittels Laserbearbeitung an der Kontaktiervorrichtung 1 angebracht wird. Zusätzlich oder alternativ ist es möglich, dass die Führungsbohrungen 5 zur Aufnahme der Kontakte 7 ebenfalls durch Laserbearbeitung erzeugt werden. Dabei kann insbesondere vorgesehen sein, dass die Führungsbohrungen 5 im gleichen Arbeitsgang mittels der Bearbeitungseinrichtung, insbesondere des Lasers, eingebracht werden, bei dem auch die mindestens eine Markierung 25 erzeugt wird. Ferner ist es bevorzugt bei der vorstehenden Bearbeitung möglich, dass die Ausbildung der Durchbrüche 26 bildenden Führungsbohrungen 5 und die Erzeugung der Markierung in derselben Aufspannung der Kontaktiervorrichtung 1 erfolgen, dass heißt, diese wird zur Bearbeitung eingespannt und bleibt in der eingespannten Position, also ohne das umgespannt wird, um sowohl die Durchbrüche 26 als auch die mindestens eine Markierung 25 zu erzeugen. Dieses Vorgehen stellt sicher, dass keine unzulässigen Toleranzen entstehen. Demgemäss ist die Lage der Markierung 25 relativ zu den Durchbrüchen 26 und demgemäss zu den Kontakten 7 hochgenau ausgebildet. Um den Kontrast der mindestens einen Markierung 25 möglichst groß auszubilden, kann der Hintergrund, auf dem sich die Markierung 25 befindet, farblich gestaltet werden, beispielsweise als Weißfeld ausgebildet werden. In dieses Weißfeld ist dann die Markierung 25 eingebracht, die als dunkle Striche erscheint, da die Führungsplatte 4 bevorzugt dunkel ausgebildet ist und demzufolge dort dunkel durchschimmert, wodurch Material (Weiß des Weißfeldes) zur Ausbildung der Markierung 25 entfernt wurde.

Besonders bevorzugt wird bei einem Ausricht- und Kontaktiervorgang eines Gegenkontakte aufweisenden Prüflings mit einer elektrische Kontakte aufweisenden Kontaktiervorrichtung wie folgt vorgegangen: Der gesamte Ausrichtvorgang (Alignmentvorgang) erfolgt als Autoalignment-Vorgang, also selbsttätig und demgemäß automatisch. Gleiches für das Kontaktieren. Das automatische Einrichten bzw. Ausrichten des Prüflings, beispielsweise des Wafers, in der erfindungsgemäßen Vorrichtung wird mittels eines Kamerasystems gesteuert. Hierdurch wird eine optimale Ausrichtung des Prüflings (z.B. Wafer) zu den Kontakten der Kontaktiervorrichtung erreicht. Bei dem mit Kontakten versehenen Halteelement der Kontaktiervorrichtung kann es sich um eine sogenannte Probe Card handeln. Die Kontakte sind als Nadeln mit feinsten Dimensionen ausgebildet, die in Führungslöchern mehrerer, dem Halteelement angehörenden Führungsplatten oder dergleichen einliegen.

Der Ausrichtvorgang läuft wie folgt ab: Der Prüfling wird auf den sogenannten Chuck geladen. Hierzu ist eine automatische Beladeeinrichtung vorgesehen. Auf dem Chuck wird der Prüfling, insbeondere Wafer, mittels Vakuum festgehalten. Nach diesem Ladevorgang wird der Prüfling, insbesondere Wafer, ausgerichtet. Dies geschieht dadurch, dass er von dem Chuck unter das Kamerasystem gefahren wird. Das Kamerasystem erkennt die Lage des Prüflings. Er wird mittels des in X- und Y-Richtung verlagerbaren und in dieser X-Y-Ebene um einen Winkel Theta verdrehbaren Chuck zu einem virtuellen X-Y-Z-System ausgerichtet. Der Chuck kann demgemäß auch in Z-Richtung verfahren. Dies ist die Richtung, um den Prüfling in Richtung auf die Kontakte der Kontaktiervorrichtung zu bewegen. Ein zweites Kamerasystem oder eine zweite Kamera des erwähnten Systems ist auf die dem Prüfling zugewandten Seite der Kontaktiervorrichtung gerichtet, d.h. die dort eingespannte Probe Card wird von diesem Kamerasystem erfasst. Das Kamerasystem sucht zunächst mit einer niedrigen optischen Auflösung nach mindestens einer erfindungsgemäßen Markierung, vorzugsweise zwei erfindungsgemäßen Markierungen. Da diese Markierungen eine definierte Lage zu den Kontakten und damit zu den Nadelspitzen der Nadeln der Kontakte der Kontaktanordnung (Nadelanordnung) haben, ist die Position der Nadelspitzen, d.h. der Kontakte der Kontaktiervorrichtung präzise durch einfache Erfassung der mindestens einen Markierung möglich und kann nunmehr entsprechend der aufgenommen Daten selbsttätig weiter verarbeitet werden. Probleme des Standes der Technik, bei dem nicht eine Markierung, sondern die Nadelspitzen erfasst werden, was aufgrund der sehr feinen Strukturen problematisch ist und zu Fehlerfassungen führen kann, sind bei der Erfindung demgemäß nicht gegeben. Diese im Stand der Technik vorhandenen Probleme treten insbesondere beim Mehrfach-Probing auf, d.h., wenn mehrere Chips eines Prüflings (Wafers) gleichzeitig getestet werden. Somit sind die elektrischen Strukturen mehrfach vorhanden. Kommt es zu Verwechslungen, dann werden die Kontakte, also die Nadeln, der Kontaktiervorrichtung z.B. fälschlicherweise auf einen Nachbarchip und nicht auf den gewünschten Chip bezogen. Das führt dazu, dass bei der Kontaktierung die Kontakte falsch auf den Wafer aufsetzen. Damit ergibt sich ein Versatz und somit eine falsche Zuordnung der bei der Prüfung des Prüflings aufgenommenen Messergebnisse zu den einzelnen Chips. Aufgrund der Erfindung liegen die Kontakte, also die Nadelspitzen, in einem genau definierten lateralen Abstand zu der mindestens einen Markierung (A-lignmentmarke). Die Markierung weist entsprechende Konturen auf, um eine exakte und sichere Vorausrichtung zu ermöglichen.

Insbesondere ist vorgesehen, dass die erfindungsgemäße Markierung bzw. die erfindungsgemäßen Markierungen so gestaltet sind, dass sie sowohl für eine Vorausrichtung (Erfassung einer Grobstruktur) als auch für eine Feinausrichtung (Erfassung einer Feinstruktur) geeignet sind. Auf das aus dem Stand der Technik bekannte fehleranfällige Ausrichten auf Nadelspitzen kann somit ganz verzichtet werden. Bei der Feinausrichtung arbeitet das entsprechende Kamerasystem mit einer gegenüber der Vorausrichtung höheren optischen Auflösung und kann daher noch genauer die Ausrichtung vornehmen, bevor ― nach exakter Feinausrichtung ― der Chuck den Prüfling (Wafer) in Z-Richtung verfährt, so dass die Kontakte und Gegenkontakte präzise gegeneinander treten und somit eine einwandfreie, fehlerfreie Kontaktierung vorliegt.

Insbesondere ist vorgesehen, dass mindestens zwei Markierungen so platziert sind, das sie denselben Abstand zu einem gewählten Zentrum des X-Y-Systems der Kontaktanordnung (Nadelanordnung) haben, um eine exakte X-Y-Theta-Ausrichtung zu ermöglichen. Für eine Theta-Ausrichtung ist es erforderlich, den Prüfling um das "richtige" Zentrum zu verschwenken. Das Zentrum liegt bei unsymmetrischen oder symmetrischen Nadelanordnungen etwa über die Kontur der Nadelanordnung gesehen im "Schwerpunkt". Es handelt sich hierbei um einen optischen "Schwerpunkt". Insbesondere bei unsymmetrischen Kontaktanordnungen (Nadelanordnungen) der Kontaktvorrichtung könnte es sonst zu einem Problem kommen, da die Kontaktiervorrichtung bei einem -X und/oder -Y-Versatz bzw. bei einem +X und/oder +Y-Versatz bei dem Versuch, die Y-Versätze zu korrigieren, immer von einer reinen Theta-Verdrehung ausgeht. So würde es im Falle einer unsymmetrischen Nadelanordnung zu einer suboptimalen Korrektur kommen. Das erfindungsgemäße System wählt sich demgemäß selbst ein Drehpunkt (Zentrum). Der Drehpunkt wird sozusagen im optischen Schwerpunkt der Nadelanordnung angenommen. Da sich der Verdrehwinkel (Theta-Winkel) jedoch mit der Lage des Drehpunkts ändert, ist bei der Erfindung derart vorgegangen, dass zwei Markierungen zwischen sich das Zentrum (Drehpunkt) aufweisen. Da die beiden Markierungen etwa gleich weit vom Drehpunkt entfernt sind, führt eine Theta-Korrektur zu optimalen Ergebnissen.

Aufgrund der Erfindung ist ein Versatz auf die falsche Chipreihe des Prüflings ausgeschlossen, da die entsprechende erfindungsgemäße Markierung (Alignment-Marke) im Fokus der Kamera des Kamerasystems nur einmal vorhanden ist. Erfindungsgemäß kommt es zu einer beschleunigten Ausrichtung, da die erfindungsgemäße Markierung bzw. die erfindungsgemäßen Markierungen durch ihre Konturengröße schnell gefunden wird/werden und auch sicher erkannt wird/werden und überdies eine hochgenaue Erfassung ermöglicht.

Wie bereits erwähnt, wird nach der Vorausrichtung und der anschließenden Feinausrichtung dann der Test, also die Prüfung des Prüflings durchgeführt. Gestartet wird mit dem (den) über ein Datenverarbeitungsprogramm der Steuereinrichtung bzw. Auswerteeinrichtung festgelegten Chip (Chips). Die einzelnen Testschritte über den gesamten Wafer, also das Kontaktieren der benachbarten Chips während des Tests wird anschließend "blind" vorgenommen, d.h., es erfolgt kein weiteres Ausrichten mittels des Kamerasystems, da die entsprechenden Chipzuordnungen dem Programm bekannt sind. Erst wenn der nächste Wafer zu testen ist, wird eine neue Ausrichtung ― vorstehend beschrieben ― vorgenommen. Die Anordnung ist stets so getroffen, dass nur der Prüfling, nicht jedoch die Kontaktiervorrichtung ausgerichtet wird.

## Patentansprüche

1. Verfahren zum elektrischen Prüfen eines Prüflings, der über eine Kontaktiervorrichtung mit einer elektrischen Prüfeinrichtung verbunden wird, wobei die Kontaktiervorrichtung an mindestens einem Halteelement mehrere elektrische Kontakte für die Kontaktierung von Gegenkontakten des Prüflings aufweist und wobei mittels Unterstützung optischer Erfassungen von Kontaktiervorrichtung und Prüfling die Kontakte und Gegenkontakte zueinander positioniert werden, **dadurch gekennzeichnet, dass** zur Positionsbestimmung mindestens eine eine definierte Lage zu mindestens einem der Kontakte aufweisende Markierung der Kontaktiervorrichtung optisch erfasst wird.

2. Verfahren nach Anspruch 1, **dadurch gekennzeichnet, dass** als Markierung mindestens eine Markierung des Halteelements optisch erfasst wird.

3. Verfahren nach einem der vorhergehenden Ansprüche, **dadurch gekennzeichnet, dass** für die Ausrichtung von Kontaktiervorrichtung und Prüfling der Prüfling relativ zur ortsfesten Kontaktiervorrichtung positioniert/verlagert wird.

4. Verfahren nach einem der vorhergehenden Ansprüche, **dadurch gekennzeichnet, dass** die mindestens eine Markierung seitlich von den Kontakten angeordnet wird.

5. Verfahren nach einem der vorhergehenden Ansprüche, **dadurch gekennzeichnet, dass** der Prüfling an/auf einer verlagerbaren Unterlage (Chuck) gehalten wird.

6. Verfahren nach einem der vorhergehenden Ansprüche, **dadurch gekennzeichnet, dass** der Prüfling per Unterdruck an/auf der Unterlage gehalten wird.

7. Verfahren nach einem der vorhergehenden Ansprüche, **dadurch gekennzeichnet, dass** als Prüfling ein Wafer geprüft wird.

8. Verfahren nach einem der vorhergehenden Ansprüche, **dadurch gekennzeichnet, dass** als Kontaktiervorrichtung eine Prüfkarte (Probe Card) verwendet wird.

9. Verfahren nach einem der vorhergehenden Ansprüche, **dadurch gekennzeichnet, dass** die Unterlage und/oder der Prüfling für die Ausrichtung in X-Richtung, in Y-Richtung und bezüglich eines Drehwinkels (θ = Theta) verlagerbar ist.

10. Verfahren nach einem der vorhergehenden Ansprüche, **dadurch gekennzeichnet, dass** mindestens zwei Markierungen der Kontaktiervorrichtung, insbesondere des Halteelements, optisch erfasst werden.

11. Verfahren nach einem der vorhergehenden Ansprüche, **dadurch gekennzeichnet, dass** die mindestens zwei Markierungen derart angeordnet werden, dass sie gleichweit oder etwa gleichweit entfernt von einem Zentrum der Anordnung der elektrische Kontakte liegen.

12. Verfahren nach einem der vorhergehenden Ansprüche, **dadurch gekennzeichnet, dass** der Prüfling unter Zuhilfenahme seiner optischen Erfassung, insbesondere bezüglich eines virtuellen Koordinatensystems in Bezug auf die optisch erfasste Lage der mindestens einen Markierung vorausgerichtet wird.

13. Verfahren nach einem der vorhergehenden Ansprüche, **dadurch gekennzeichnet, dass** nach der Vorausrichtung eine Feinausrichtung des Prüflings relativ zur Kontaktiervorrichtung, insbesondere zu deren Kontakten, erfolgt.

14. Verfahren nach einem der vorhergehenden Ansprüche, **dadurch gekennzeichnet, dass** für die Feinausrichtung die mindestens eine Markierung der Kontaktiervorrichtung optisch erfasst wird.

15. Verfahren nach einem der vorhergehenden Ansprüche, **dadurch gekennzeichnet, dass** die Vorausrichtung und/oder die Feinausrichtung durch Vergleich der optisch erfassten Ergebnisse von der Markierung und dem Prüfling erfolgt beziehungsweise erfolgen.

16. Verfahren nach einem der vorhergehenden Ansprüche, **dadurch gekennzeichnet, dass** nach der Feinausrichtung die Kontaktierung des Prüflings mittels der Kontakte in einer Prüfposition erfolgt.

17. Verfahren nach einem der vorhergehenden Ansprüche, **dadurch gekennzeichnet, dass** mindestens eine weitere Prüfposition bei der Prüfung desselben Prüflings ohne nochmaligen optischen Vergleich, sondern aufgrund geometrischer Vorgaben eingenommen wird.

18. Verfahren nach einem der vorhergehenden Ansprüche, **dadurch gekennzeichnet, dass** das Verfahren selbsttätig durchgeführt wird.

19. Verfahren nach einem der vorhergehenden Ansprüche, **dadurch gekennzeichnet, dass** die mindestens eine Markierung als Mehrfachmarkierung, insbesondere Doppelmarkierung, mit mindestens einer Grobstruktur und mindestens einer Feinstruktur ausgebildet wird und dass die Positionierung/Ausrichtung zunächst anhand der Grobstruktur mittels optischer, mit niedriger Auflösung erfolgender Erfassung der Grobstruktur und dann anhand der Feinstruktur mittels optischer, mit hoher Auflösung erfolgender Erfassung der Feinstruktur durchgeführt wird.

20. Verfahren nach einem der vorhergehenden Ansprüche, **dadurch gekennzeichnet, dass** die Feinstruktur innerhalb der Grobstruktur angeordnet wird.

21. Verfahren nach einem der vorhergehenden Ansprüche, **dadurch gekennzeichnet, dass** die Grobstruktur und die Feinstruktur mit demselben Markierungszentrum versehen sind.

22. Vorrichtung, insbesondere zur Durchführung des Verfahrens nach einem oder mehreren der vorhergehenden Ansprüche, mit einer Kontaktiervorrichtung (1) zum elektrischen Verbinden eines Prüflings (10) mit einer elektrischen Prüfeinrichtung, mit mehreren, mindestens einem Halteelement (3) zugeordneten elektrischen Kontakten (7) für die Kontaktierung von Gegenkontakten (13) des Prüflings (10), wobei die Kontaktiervorrichtung (1), vorzugsweise das Halteelement (3), mit mindestens einer Markierung (25) versehen ist, die eine definierte Lage zu mindestens einem der Kontakte (7) aufweist und mit mindestens einer die Markierung (25) und den Prüfling (10), insbesondere die elektrischen Gegenkontakte (13) des Prüflings (10), erfassenden optischen Einrichtung (21).

23. Vorrichtung nach Anspruch 22, **gekennzeichnet durch** mindestens eine Positioniereinrichtung zur selbsttätigen Ausrichtung von Kontakten (7) und Gegenkontakten (13) relativ zueinander unter Berücksichtigung der optischen Erfassung.

24. Vorrichtung nach einem der vorhergehenden Ansprüche, **dadurch gekennzeichnet, dass** die mindestens eine Markierung (25) eine Grobstruktur und eine Feinstruktur aufweist.

25. Vorrichtung nach einem der vorhergehenden Ansprüche, **dadurch gekennzeichnet, dass** die Grobstruktur und die Feinstruktur dasselbe Markierungszentrum aufweisen.

26. Vorrichtung nach einem der vorhergehenden Ansprüche, **dadurch gekennzeichnet, dass** die am Halteelement (3) angeordnete Markierung (25) gegenüber dem Halteelement (3) mit optischem Kontrast ausgebildet ist.

27. Vorrichtung nach einem der vorhergehenden Ansprüche, **dadurch gekennzeichnet, dass** die Markierung (25) auf seiner dem Prüfling (10) zugeordneten Seite des Halteelements (3) angeordnet ist.

28. Vorrichtung nach einem der vorhergehenden Ansprüche, **dadurch gekennzeichnet, dass** die Markierung (25) seitlich zu den Kontakten (7) angeordnet ist.

29. Vorrichtung nach einem der vorhergehenden Ansprüche, **dadurch gekennzeichnet, dass** das Halteelement (3) Durchbrüche (26) aufweist, in denen die Kontakte (7) angeordnet, vorzugsweise verschieblich, insbesondere vertikal verschieblich, geführt sind.

30. Vorrichtung nach einem der vorhergehenden Ansprüche, **dadurch gekennzeichnet, dass** die Kontakte (7) als Knickdrähte ausgebildet sind.

31. Verfahren zur Herstellung einer Vorrichtung, insbesondere Kontaktiervorrichtung, zum elektrischen Verbinden eines Prüflings mit einer elektrischen Prüfeinrichtung, insbesondere nach einem oder mehreren der vorhergehenden Ansprüche, mit mehreren elektrischen Kontakten, die in Durchbrüchen mindestens eines Halteelements zugeordnet sind, wobei die Kontaktiervorrichtung, insbesondere das Halteelement, mit mindestens einer Markierung versehen wird, die eine definierte Lage zu mindestens einem der Kontakte aufweist, wobei die Markierung mit derselben Bearbeitungsvorrichtung und/oder Bearbeitungsart hergestellt wird, die auch die Durchbrüche erzeugt.

32. Verfahren nach Anspruch 31, **dadurch gekennzeichnet, dass** die Ausbildung der Durchbrüche und der Markierung in derselben Aufspannung erfolgt.

33. Verfahren nach einem der vorhergehenden Ansprüche, **dadurch gekennzeichnet, dass** als Bearbeitungsart eine Laserbearbeitung und/oder eine mechanische Bearbeitung durchgeführt wird.

34. Verfahren nach einem der vorhergehenden Ansprüche, **dadurch gekennzeichnet, dass** die Markierung als Mehrfachmarkierung, insbesondere Doppelmarkierung, erzeugt wird und dass die einzelnen Markierungen der Mehrfachmarkierung mit derselben Bearbeitungsvorrichtung und/oder Bearbeitungsart und/oder in derselben Aufspannung hergestellt werden.
